# EUROPÄISCHE PATENTSCHRIFT

(11) **EP 1 421 619 B1**
(45) Veröffentlichungstag und Bekanntmachung des Hinweises auf die Patenterteilung: **07.03.2012**
(21) Anmeldenummer: 02797604.2
(22) Anmeldetag: 21.08.2002
(51) Int. Cl.: H01L 23/528, H01L 21/768, H01L 29/417, H01L 21/8249

(54) **KONTAKTIERUNG DES EMITTERKONTAKTS EINER HALBLEITERVORRICHTUNG**
CONNECTING THE EMITTER CONTACTS OF A SEMICONDUCTOR DEVICE
MISE EN CONTACT DU CONTACT D'EMETTEUR D'UN DISPOSITIF A SEMI-CONDUCTEUR

(30) Priorität: 31.08.2001 DE 10142690
(43) Veröffentlichungstag der Anmeldung: 26.05.2004
(73) Patentinhaber: Infineon Technologies AG, 85579 Neubiberg (DE)
(72) Erfinder: GOLLER, Klaus, 01069 Dresden (DE)
(74) Vertreter: Müller-Boré & Partner Patentanwälte
(86) Internationale Anmeldenummer: PCT/EP2002/009346
(87) Internationale Veröffentlichungsnummer: WO 2003/021676

(56) Entgegenhaltungen:
- GB-A- 2 270 419
- US-A- 4 902 637
- US-A- 5 587 599
- US-B1- 6 281 051
- HAFIZI M: "NEW SUBMICRON HBT IC TECHNOLOGY DEMONSTRATES ULTRA-FAST, LOW-POWER INTEGRATED CIRCUITS" IEEE TRANSACTIONS ON ELECTRON DEVICES, IEEE INC. NEW YORK, US, Bd. 45, Nr. 9, 1. September 1998 (1998-09-01), Seiten 1862-1868, XP000782088 ISSN: 0018-9383

## Beschreibung

Die Erfindung betrifft eine Halbleitervorrichtung gemäß Ansprüchen 1 und 10 sowie ein Verfahren zur Herstellung einer Halbleitervorrichtung gemäß Ansprüchen 5 und 12.

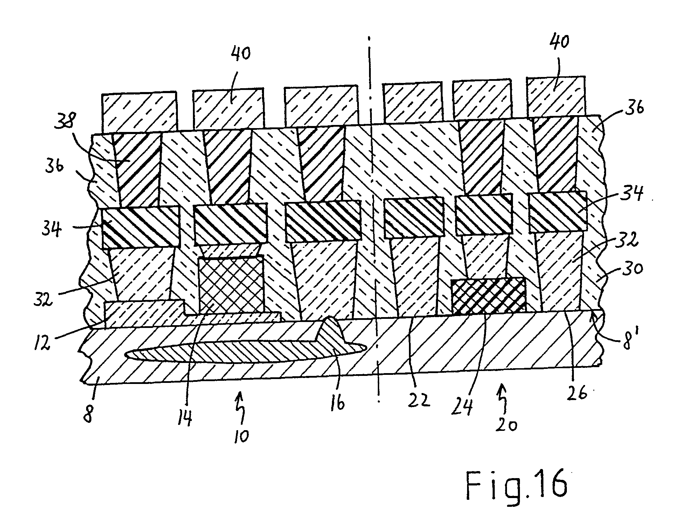

In **Fig. 16** ist eine herkömmliche Halbleitervorrichtung gezeigt, anhand welcher die Probleme des Standes der Technik, auf die sich die Erfindung bezieht, aufgezeigt werden. Die Halbleitervorrichtung umfaßt einen (vertikalen) Bipolartransistor 10, welcher in bekannter Weise einen Basiskontakt 12, einen Emitterkontakt 14 sowie einen Kollektorkontakt 16 aufweist. Bei dem Bipolartransistor 10 kann es sich um einen npn-Transistor oder um einen pnp-Transistor handeln, welcher beispielsweise Bestandteil eines Hochfrequenzschaltkreises der Halbleitervorrichtung ist. Auf dem gleichen Substrat 8 (beispielsweise ein Siliziumwafer) kann zusätzlich eine CMOS-Schaltung vorgesehen, welche im einfachsten Fall aus einem MOS-Transistor 20 mit einem Sourcekontakt 22, einem Gatekontakt 24 und einem Drainkontakt 26 besteht.

Charakteristisch für derartige Bipolar-CMOS-Schaltungen ist, daß der Emitterkontakt (der sogenannte Emitterstack) 14 deutlich "höher" als alle übrigen.Kontakte über der Prozeßoberfläche 8' des Substrats 8 ausgebildet wird. Die der Prozeßoberfläche 8' des Substrats 8 abgewandte Kontaktfläche des Emitterkontakts 14 weist einen größeren Abstand von der Prozeßoberfläche 8' als Kontaktflächen der übrigen Kontakte 12, 16, 22, 24 bzw. 26 auf. Diese vergleichsweise große Höhe des Emitterkontakts 14 ergibt sich aus notwendigen Prozeßanforderungen eines optimierten Bipolartransistors.

Beispielsweise weist ein Bipolartransistor gemäß dem Infineon B9C-Prozeß eine Gesamthöhe des Emitterkontakts 14 über der Prozeßoberfläche 8' von typischerweise 550 nm auf. Demgegenüber ist beispielsweise der Polysilizium-Gatekontakt 24 eines auf dem gleichen Substrat 8 angeordneten MOS-Transistors 20 lediglich typischerweise 280 nm hoch.

Diese erheblich unterschiedlichen Abstände der Kontaktfläche des Emitterkontaktes 14 zu den übrigen Kontakten führt zu gravierenden prozeßtechnischen Problemen bei der Verbindung dieser Kontakte über Kontaktlöcher 32 mit einer ersten strukturierten Metallebene 34 (der sogenannten Metal-1-Ebene), welche im folgenden beschrieben werden.

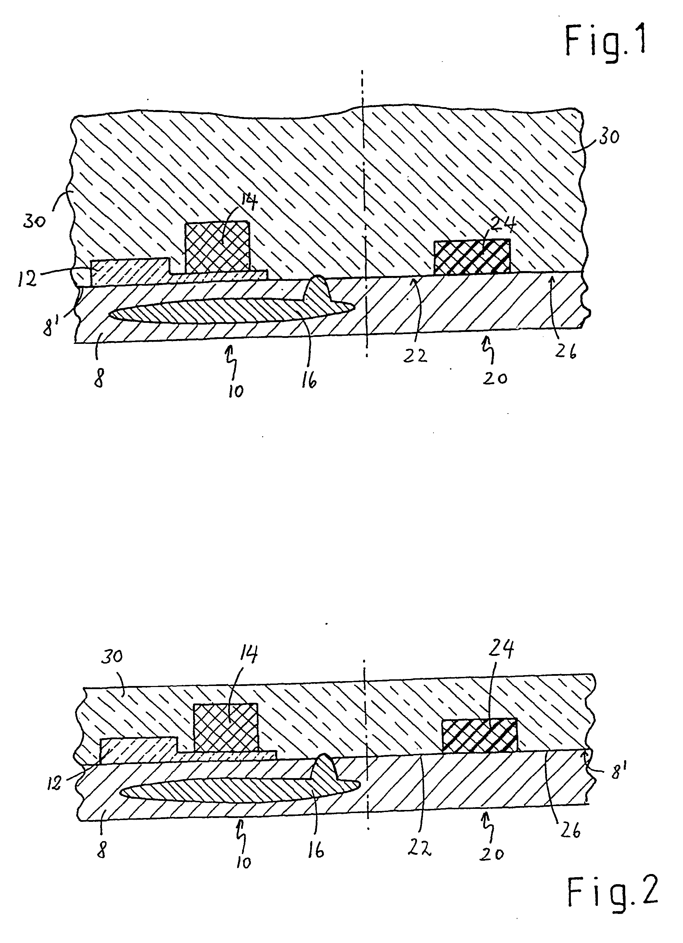

Alle aktiven Bauelemente der Halbleitervorrichtung (d.h. die Bipolar- und CMOS-Transistoren) werden nach dem Prozeßende FEOL (front end of line) typischerweise mit einem Dielektrikum 30, beispielsweise BPSG (Bor-Phosphor-Silikat-Glas), bis zu einer Gesamthöhe von etwa 1400 nm abgedeckt. In Fig. 1 ist eine Halbleitervorrichtung nach dem Abscheideschritt dieser Isolatorschicht 30 (BPSG-Schicht) gezeigt. In diesem Prozeßstadium unterscheidet sich eine erfindungsgemäße Halbleitervorrichtung noch nicht vom Stand der Technik.

Nachfolgend wird die Isolatorschicht 30 durch einen chemischmechanischen Planarisierungsschritt (Schritt: CMP BPSG) bis zu einer spezifizierten Zieldicke planar zurückpoliert. Die nach Beendigung dieses Polierschritts erhaltene Halbleitervorrichtung ist schematisch in **Fig. 2** dargestellt.

Durch den hohen Emitterkontakt 14 ist der planare polierschritt (Schritt: CMP BPSG) äußerst kritisch. Während bei dem Infineon-C9N-Prozeß, bei welchem es sich um einen CMOS-Logik-Prozeß der neunten Generation mit 0,25 µm-Technologie handelt, dieser planare Polierschritt aufgrund der vergleichsweise geringen Höhe des Gatekontakts 24 (etwa 280 nm über der Substratoberfläche) keine prozeßtechnische Herausforderung darstellt, würde die unmittelbare Übernahme der Prozeßspezifikation des C9N CMP BPSG-Schritts zu einer empfindlichen Einbuße der Herstellungsausbeute (yield) führen.

So wird gemäß dem C9N-Prozeß die Isolatorschicht 30 (die BPSG-Schicht) in dem Polierschritt CMP BPSG auf eine Gesamthöhe von 700 nm ± 150 nm zurückpoliert. Gemittelt über den gesamten Wafer ist somit minimal eine BPSG-Schichtdicke von 550 nm über der Substratoberfläche vorhanden, so daß über dem Gatekontakt 24 minimal eine BPSG-Schicht 30 mit einer Höhe von 270 nm verbleibt. Lokal kann die BPSG-Schichtdicke von typischerweise 550 nm infolge ortsabhängiger Belegungsdichten der aktiven Bauelemente unterschritten werden. Somit sind die für einen reinen Logikbasisprozeß gemäß C9N erzielten Schichthöhen der Isolatorschicht 30 unkritisch, so daß sich für den CMP BPSG Schritt ein verhältnismäßig breites Prozeßfenster ergibt.

Wenn jedoch ein Bipolartransistor 10 als aktives Bauelement der Halbleitervorrichtung (eventuell zusätzlich zu einem CMOS Transistor 20) vorgesehen ist, stellt sich die prozeßtechnische Situation anders dar. Wird nämlich die Spezifikation des Polierschritts der Isolatorschicht 30 (CMP BPSG) unmittelbar von dem CMOS-Logik-Prozeß (Infineon C9N-Prozeß: Schichthöhe BPSG 700 nm ± 150 nm) auf den Bipolar-CMOS-Prozeß (Infineon B9C-Prozeß) übernommen, so kann sich ungünstigsten Falls bei einer Emitterkontakthöhe von 550 nm über dem Substrat 8 eine lediglich wenige Nanometer hohe BPSG-Isolatorschicht 30 ergeben. Diese sehr dünne Isolatorschicht 30 über dem Emitterkontakt 14 ist für eine nachfolgende Strukturierung eines Kontaktlochs 32 nicht geeignet. Folglich ist das Prozeßfenster für den Planarisierungsschritt (CMP BPSG) bei B9C-Prozeßtechnologie stark reduziert.

Ferner ist zu erwarten, daß zukünftige Bipolar-Transistorgenerationen, welche insbesondere Silizium-Germanium-Heterobipolartransistoren umfassen, noch höhere Emitterkontakte (Emitterstacks) gegenüber den übrigen Kontakten (beispielsweise dem Gatekontakt-Polystack) aufweisen werden, wodurch sich dieses Problem noch verschärfen würde.

Ein weiteres, mit dem relativ hohen Emitterkontakt 14 zusammenhängendes Problem herkömmlicher Halbleitervorrichtungen liegt in den hohen prozeßtechnischen Anforderungen an den Strukturierungsschritt der Kontaktlöcher 32 (CT) begründet, über welche die Kontakte 12, 14, 16, 22, 24 und 26 jeweils standardmäßig mit der ersten strukturierten Metallebene 34 verbunden werden. So muß der Ätzschritt (Schritt: CT Etch) der Kontaktlöcher 32, bei welchem es sich typischerweise um einen Plasmaätzschritt handelt, hoch selektiv gegenüber dem Emitterkontakt 14 (Polysiliziumkontakt) sein, um auch die am "tiefsten" gelegenen Kontaktflächen (d.h. die am nächsten zur Prozeßoberfläche 8' des Substrats 8 gelegenen Flächen) zuverlässig und restefrei öffnen zu können ohne den Emitterkontakt 14 anzugreifen. Bei den obengenannten Spezifikationen des C9N-Prozesses können beispielsweise Sourcekontakt 22 und Drainkontakt 26 des MOS-Transistors 20 maximal 850 nm unterhalb der Isolatorschicht 30 nach dem Polierschritt (CMP BPSG) "vergraben" sein.

Um diese substratnah gelegenen Kontakte 22 bzw. 26 restefrei mit dem Plasmaätzschritt öffnen zu können, ist eine vergleichsweise lange Ätzzeit notwendig. Diese lange Ätzzeit in Verbindung mit einer BPSG-Schichtdicke von 700 nm ± 150 nm bedeutet für eine minimale Dicke von 550 nm, daß bereits nach einer kurzen Ätzzeitdauer die Ätzungfront des Kontaktlochs 32, welches sich über dem Emitterkontakt 14 befindet, auf der Kontaktfläche des Emitterkontakts 14 angelangt sein wird. Von diesem Zeitpunkt an ist der Emitterkontakt 14 mit seiner Kontaktfläche der Plasmaätze ausgesetzt. Nur wenn der Plasmaätzschritt (durch Zugabe geeigneter Passivierungsverbindungen in das Ätzplasma) hoch selektiv den Isolator 30 (z.B. BPSG) gegenüber dem Kontaktmaterial (z.B. Polysilizium) ätzt, kann eine Fortführung des Ätzprozesses zur Öffnung der tief gelegenen Kontakte erfolgen, ohne daß der Emitterkontakt 14 angegriffen wird. Diese prozeßtechnische Herausforderung kann zu einer weiteren empfindlichen Ausbeuteeinbuße führen.

Neben den prozeßtechnologischen Schwierigkeiten, welche die oben beschriebene herkömmliche Halbleitervorrichtung bei ihrer Herstellung mit sich bringt (kritische Prozeßfenster der Prozeßschritte CMP BPSG und CT Etch), ist bei derartigen, bekannten Halbleitervorrichtungen die Kontaktfläche des Emitterkontakts 14 nachteiligerweise auf die Fläche des Kontaktlochs 32 beschränkt. Bipolarapplikationen, welche große Emitter-Kollektor-Stromstärken erfordern, lassen sich durch die nicht optimale Ausnutzung des Querschnitts des Emitterkontakts 14 nur begrenzt realisieren.

Die oben beschriebenen Probleme bei der Herstellung der bekannten Halbleitervorrichtung wurden bislang dadurch gelöst, daß die aus dem C9N-Prozeß abgeleitete Spezifikation des Polierschritts (CMP BPSG) der Isolatorschicht 30 "aufgeweitet" wurde. Während bei dem C9N-Prozeß für die Schichthöhe der Isolatorschicht 30 eine Spezifikation von 700 nm ± 150 nm nach dem Planarisierungsschritt gefordert wurde, wurde bei dem Bipolar-CMOS-Prozeß (Infineon B9C-Prozeß) lediglich eine Schichthöhe der Isolatorschicht 30 von 750 nm ± 150 nm über der Prozeßoberfläche 8' verlangt.

Wird die Höhe des Emitterkontakts um 50 nm reduziert (auf nunmehr 500 nm), wird gleichsam das Prozeßfenster für den Ätzschritt der Kontaktlöcher 32 eingeschränkt, da nunmehr eine geringere "Reserve" an Polysilizium des Emitterkontakts 14, welches von der Kontaktlochätzung (CT Etch) angegriffen werden kann, vorhanden ist. Hierdurch reduziert sich das Prozeßfenster des Plasmaätzschritts der Kontaktlöcher 32.

US 4 902 637 A beschreibt eine dreidimensionale Struktur einer Halbleitervorrichtung, mit einer ersten Schicht mit MOS-Transistoren und einer zweiten Schicht mit MOS-Transistoren, die durch eine Isolatorschicht voneinander getrennt sind. Über den Schichten mir MOS-Transistoren befinden sich jeweils Anschlussschichten, wobei die Anschlussschicht der zweiten Schicht über der Anschlussschicht der ersten Schicht liegt. In den MOS-Transistoren sind die Kontaktflächen der Gates weiter vom darunter befindlichen Halbleitersubstrat entfernt als die Kontaktflächen von Source und Drain. Bei einem der Transistoren ist die Kontaktfläche des Gates an die Anschlussschicht der zweiten Schicht angeschlossen, wohingegen die Kontaktfläche von Source und Drain an die Anschlussschicht der ersten Schicht angeschlossen sind.

Ein weiterer relevanter Stand der Technik wird in dem Dokument US-A-4 902 637 beschrieben. Es zeigt eine Halbleitervorrichtung mit
- einem Substrat, dessen Prozessoberfläche eine Substratnormalenrichtung aufweist ;
- einem ersten und einem zweiten auf dem Substrat angeordneten Kontakt, wobei eine Kontaktfläche des zweiten Kontakts in Substratnormalenrichtung weiter von dem Substrat als eine Kontaktfläche des ersten Kontakts beabstandet ist; und
- einer ersten und einer zweiten strukturierten Metallebene, in weichen jeweils zumindest ein Leiter ausgebildet ist, der mit zumindest einem der Kontakte verbindbar ist;
wobei die zweite Metallebene in Substratnormalenrichtung weiter von dem Substrat als die erste Metallebene beabstandet ist,
der erste Kontakt mit einem darüberliegenden aktiven Gebiet über in Substratnormalenrichtung über dem ersten Kontakt liegende verfüllte Kontaktlöcher und unter Zwischenschaltung eines in Substratnormalenrichtung über dem ersten Kontakt liegenden Leiters der ersten Metallebene elektrisch verbunden ist, und
der zweite Kontakt mit einem in Substratnormalenrichtung darüberliegenden Leiter der zweiten Metallebene ohne Zwischenschaltung eines Leiters der ersten Metallebene elektrisch verbunden ist.

Angesichts der oben genannten Nachteile herkömmlicher Halbleitervorrichtungen bzw. ihrer Herstellungsverfahren ist es Aufgabe der Erfindung, eine Halbleitervorrichtung mit Kontakten, die unter Zwischenschaltung von Leitern einer ersten Metallebene mit Leitern einer zweiten, höher liegenden Metallebene verbunden sind, sowie ein Herstellungsverfahren für eine solche Halbleitervorrichtung derart zu verbessern, dass die Höhe eines Kontakts (beispielsweise des Emitterkontakts 14) frei gewählt werden kann, ohne dadurch die Prozessierung der Halbleitervorrichtung nachhaltig zu erschweren.

Diese Aufgabe wird durch ein Verfahren zur Herstellung einer Halbleitervorrichtung gemäß Anspruch 1 gelöst. Bevorzugte Ausführungsformen sind Gegenstand der abhängigen Ansprüche.

Wie oben bereits beschrieben worden ist, werden üblicherweise sämtliche Kontakte der aktiven Bauelemente herkömmlicher Halbleitervorrichtungen typischerweise über sogenannte Kontaktlöcher (CT) mit in Substratnorinalenrichtung darüberliegenden Leitern einer ersten strukturierten Metallebene verbunden. Ist das aktive Bauelement der Halbleitervorrichtung beispielsweise ein Bipolartransistor, so sind jeweilige Leiter der ersten strukturierten Metallebene mit dem Basis-, dem Emitter- und dem Kollektorkontakt des Transistors verbunden.

Gemäß der Erfindung wird jedoch ein anderer Weg eingeschlagen So wird erfindungsgemäß ein Kontakt, dessen Kontaktfläche einen großen Abstand von der Prozeßoberfläche des Substrats aufweist, nicht mit einem Leiter der ersten Metallebene verbunden. Stattdessen erfolgt die Kontaktierung dieses Kontakts erst in einem späteren Prozeßstadium beispielsweise durch ein Kontaktloch zu einer zweiten strukturierten Metallebene, welche in Substratnormalenrichtung über der ersten strukturierten Metallebene angeordnet ist. Folglich kann der zweite Kontakt, welcher gegenüber den übrigen Kontakten eine große Kontakthöhe über der Prozeßoberfläche aufweist, in seiner Höhe frei dimensioniert werden, da er nicht gemeinsam mit den übrigen Kontakten über die erste strukturierte Metallebene kontaktiert werden muß.

Über dem zweiten (hohen) Kontakt in Substratnormalenrichtung ist kein Leiter der ersten Metallebene angeordnet. Stattdessen befindet sich über dem zweiten Kontakt lediglich ein Leiter der zweiten Metallebene, welcher mit der Kontaktfläche des zweiten Kontakts beispielsweise über einen Wolfram-Kontaktzapfen verbunden ist.

Besondere Vorteile ergeben sich bei dieser Halbleitervorrichtung dadurch, daß typischerweise ohnehin nach der Prozessierung der ersten Metallebene weitere vertikale Verbindungskontakte (sogenannte VIA-Verbindungskontakte) zur Verbindung gewisser Leiter der ersten Metallebene mit darüberliegenden Leitern der zweiten Metallebene vorgesehen sind. Der zweite Kontakt kann somit über die VIA-1-Verbindungskontakte mit der zweiten Metallebene kontaktiert werden, so daß keine zusätzlichen Lithographie-, Reinigungs-, Metallisierungs- und Polierschritte zur Kontaktierung des zweiten Kontakts über die höherliegende Metallebene notwendig sind.

Der zweite Kontakt ist ein Emitterkontakt eines Bipolartransistors und der erste Kontakt ein Basis- oder Kollektorkontakt eines Bipolartransistors oder ein Source-, Gate- oder Drainkontakt eines MOS-Transistors. Wie bereits eingangs beschrieben worden ist, weist der Emitterkontakt eines Bipolartransistors verglichen mit den übrigen Kontakten der aktiven Bauelemente einer Halbleitervorrichtung typischerweise die größte Höhe über der Prozeßoberfläche des Substrats auf. Es ist somit vorteilhaft, den (vergleichsweise hohen) Emitterkontakt nicht mit einem Leiter der ersten Metallebene zu verbinden, sondern - beispielsweise über einen VIA-1-Kontakt - lediglich mit einem Leiter der zweiten Metallebene. Über dem Emitterkontakt liegt somit kein Leiter der ersten Metallebene.

Der erste Kontakt ist mit dem Leiter der ersten Metallebene über ein sich in Substratnormalenrichtung erstreckendes und mit einem elektrisch leitfähigen Kontaktlochfüllmaterial gefülltes Kontaktloch verbunden. Das Kontaktlochfüllmaterial kann beispielsweise Wolfram sein, welches mit einem MCVD-Verfahren in ein zuvor plasmageätztes Kontaktloch eingebracht wird. Als Diffusionsstopp kann an sämtlichen Grenzflächen (insbesondere zwischen dem Kontaktlochfüllmaterial und der Metallebene bzw. dem Kontaktmaterial) ein sogenannter Liner, beispielsweise ein TiN-Liner, vorgesehen sein.

Vorzugsweise ist der zweite Kontakt mit dem Leiter der zweiten Metallebene über ein sich in Substratnormalenrichtung erstreckendes und mit einem elektrisch leitfähigen Kontaktlochfüllmaterial gefülltes Kontaktloch ohne Zwischenschaltung eines Leiters der ersten Metallebene verbunden. Wie oben bereits ausgeführt worden ist, kann es sich bei dem Kontaktloch um den sogenannten VIA-1-Verbindungskontakt handeln, welcher normalerweise Leiter der zweiten strukturierte Metallebene mit entsprechenden der ersten strukturierten Metallebene verbindet. Erfindungsgemäß kann dieser VIA-1-Verbindungskontakt eingesetzt werden, um den zweiten Kontakt bzw. mehrere hochliegende Kontakte) zu kontaktieren. Zwischen dem enstprechenden Leiter der zweiten Metallebene und der Kontaktfläche des zweiten Kontakts ist in Substratnormalenrichtung kein Leiter der ersten Metallebene angeordnet.

Gemäß der Erfindung umfaßt ein Verfahren zur Herstellung einer Halbleitervorrichtung, die in Anspruch 1 angegebenen Schritte.

Demgemäß wird bei einem Herstellungsverfahren einer Halbleitervorrichtung gemäß der Erfindung der zweite, in Substratnormalenrichtung weiter von der Prozeßoberfläche beabstandete Kontakt nicht mit einem Leiter der ersten Metallebene verbunden, sondern lediglich mit einem in Substratnormalenrichtung darüberliegenden Leiter der zweiten Metallebene.

Hierdurch vereinfacht sich die Strukturierung der elektrischen Verbindungen der übrigen Kontakte zu der ersten strukturierten Metallebene erheblich. Denn auf den (hochliegenden) zweiten Kontakt bzw. auf eine Vielzahl derartiger hochliegender zweiter Kontakte muß bei der prozeßtechnischen Realisation der elektrischen Verbindung des ersten Kontakts zu der ersten Metallebene keine Rücksicht genommen werden. Stattdessen können die Strukturierungs- und Prozeßparameter für die Kontaktierung des ersten Kontakts (bzw. der ersten Kontakte) für deren Kontaktierung optimiert werden. Gleichzeitig kann der zweite Kontakt in seiner Kontakthöhe (d.h. seines Abstands von der Prozeßoberfläche in Normalenrichtung des Substrats) frei gewählt werden (unter gleichzeitiger Anpassung der BPSG-Schichtdicke, deren minimale Höhe gleich oder größer als die resultierende Kontakthöhe des zweiten Kontakts sein muß), um optimale Strukturierungs- und Bauelementeigenschaften zu gewährleisten.

Der zweite Kontakt ist ein Emitterkontakt eines Bipolartransistors und der erste Kontakt ein Basis- oder Kollektorkontakt eines Bipolartransistors oder ein Source-Gate- oder Drainkontakt eines MOS-Transistors.

Der Schritt des elektrischen Verbindens des ersten Kontakts umfasst folgenden Schschritt:
- Definieren eines auf dem ersten Kontakt endenden, sich in Substratnormalenrichtung erstreckenden Kontaktlochs in einem Isolator; und vorzugsweise auch folgende Schritte
- Füllen des Kontaktlochs mit einem elektrisch leitfähigen Kontaktlochfüllmaterial; und
- Definieren des in Substratnormalenrichtung über dem ersten Kontakt liegenden Leiters der ersten Metallebene derart, daß dieser mit dem Kontaktlochfüllmaterial elektrisch verbunden ist.

Beispielsweise wird nach Fertigstellung der aktiven Bauelemente der Halbleitervorrichtung (Prozessende FEOL) ein dielektrischer Isolator wie BPSG (Bor-Pphosphor-Silikat-Glas) mittels eines CVD Verfahrens auf der Halbleitervorrichtung abgeschieden, durch einen nachfolgenden Planarisierungsschritt (CMP BPSG) auf eine Zielhöhe zurückpoliert und mittels gängiger Lithographie- und Ätzschritte strukturiert. Das entstehende, sich entlang der Substratnormalenrichtung erstreckende Kontaktloch endet auf dem zu kontaktierenden ersten Kontakt bzw. den zu kontaktierenden ersten Kontakten. Durch einen MCVD-Metallisierungsschritt kann dieses Kontaktloch nachfolgend mit einem elektrisch leitfähigen Kontaktlochfüllmaterial, vorzugsweise Wolfram, gefüllt werden. Vorzugsweise wird nachfolgend ein Leiter der ersten Metallebene derart auf dem erneut planarisierten Wolfram-Kontaktzapfen angeordnet, daß dieser mit dem ersten Kontakt elektrisch leitfähig verbunden ist.

Vorzugsweise umfaßt der Schritt des elektrischen Verbindens des zweiten Kontakts folgende Schritte:
- Definieren eines auf dem zweiten Kontakt endenden, sich in Substratnormalenrichtung erstreckenden Kontaktlochs in einem Isolator;
- Füllen des Kontaktlochs mit einem elektrisch leitfähigen Kontaktlochfüllmaterial; und
- Definieren des in Substratnormalenrichtung über dem zweiten Kontakt liegenden Leiters der zweitens Metallebene derart, daß dieser mit dem Kontaktlochfüllmaterial ohne Zwischenschaltung eines Leiters der ersten Metallebene elektrisch verbunden ist.

Vorzugsweise wird gleichzeitig mit dem Schritt des elektrischen Verbindens des zweiten Kontakts mit dem Leiter der zweiten Metallebene zumindest ein Leiter der ersten Metallebene mit einem Leiter der zweiten Metallebene verbunden. Der zweite Kontakt wird demgemäß vorzugsweise übers den sogenannten VIA-1-Verbindungskontakt mit einem Leiter der zweiten Metallebene elektrisch leitfähig verbunden. Die Prozessierung dieser VIA-1-Verbindungskontakte gehört zu den Standardprozessen derartiger Halbleitervorrichtungen, so daß zur Kontaktierung des zweiten Kontakts keine zusätzlichen Strukturierungsschritte gegenüber herkömmlichen Prozessierungsverfahren notwendig sind.

Gemäß einem zweiten Aspekt, welcher hiermit als technologischer Hintergrund der Erfindung beschrieben wird, umfaßt eine Halbleitervorrichtung
- ein Substrat, dessen Prozeßoberfläche eine Substratnormalenrichtung aufweist;
- zumindest einen ersten und einen zweiten auf dem Substrat angeordneten Kontakt, wobei eine Kontaktfläche des zweiten Kontakts in Substratnormalenrichtung weiter von dem Substrat als eine Kontaktfläche des ersten Kontakts beabstandet ist; und
- zumindest eine strukturierte Metallebene, in welcher zumindest ein erster und ein zweiter Leiter ausgebildet ist, die jeweils mit einem der Kontakte verbindbar sind;
wobei der erste Kontakt mit dem in Substratnormalenrichtung darüberliegenden ersten Leiter der Metallebene über ein sich in Substratnormalenrichtung erstreckendes und mit einem elektrisch leitfähigen Kontaktlochfüllmaterial gefülltes Kontaktloch elektrisch verbunden ist und der zweite Kontakt unmittelbar an den in Substratnormalenrichtung darüberliegenden zweiten Leiter der Metallebene angrenzt, so daß der zweite Kontakt mit dem zweiten Leiter ohne Zwischenschaltung eines gefüllten Kontaktlochs elektrisch verbunden ist.

Gemäß dem zweiten Aspekt wird der zweite Kontakt (d.h. der höherliegende Kontakt) nicht über ein Kontaktloch mit einem Leiter der (z.B. ersten) Metallebene elektrisch verbunden. Stattdessen erfolg die elektrische Verbindung unmittelbar ohne Zwischenschaltung eines elektrischen Kontaktlochs dadurch, daß der zweite Leiter der Metallebene an die Kontaktfläche des zweiten Kontakts angrenzt. Folglich kann die Prozessierung der Kontaktlöcher für die übrigen Kontakte ohne Berücksichtigung des hohen zweiten Kontakts erfolgen, so daß die Strukturierung der Kontaktlöcher zur Verbindung des ersten Kontakts mit der Metallebene verglichen zu den eingangs beschriebenen herkömmlichen Halbleitervorrichtungen unkritisch ist.

Die Kontaktfläche des zweiten Kontakts wird nicht durch einen Plasmaätzschritt eines Kontaktlochs geöffnet, sondern vorzugsweise durch einen Polierschritt (CMP-Schritt). Folglich kann die Höhe des zweiten Kontakts frei gewählt werden bzw. an die Prozessanforderungen eines optimierten aktiven Bauelements angepaßt werden.

Vorzugsweise ist der zweite Kontakt ein Emitterkontakt eines Bipolartransistors und der erste Kontakt ein Basis- oder Kollektorkontakt oder ein Source-, Gate oder Drainkontakt eines MOS-Transistors.

Gemäß dem zweiten Aspekt umfaßt ein Verfahren zur Herstellung einer Halbleitervorrichtung, vorzugsweise einer Halbleitervorrichtung gemäß dem zweiten Aspekt, folgende Schritte:
- Bereitstellen eines Substrats, dessen Prozeßoberfläche eine Substratnormalenrichtung aufweist;
- Definieren zumindest eines und eines zweiten Kontakts auf dem Substrat, wobei eine Kontaktfläche des zweiten Kontakts in Substratnormalenrichtung weiter von dem Substrat als eine Kontaktfläche des ersten Kontakts beabstandet ist;
- elektrisches Verbinden des ersten Kontakts mit einem in Substratnormalenrichtung darüberliegenden ersten Leiter einer strukturierten Metallebene über ein sich in Substratnormalenrichtung erstreckendes und mit einem elektrisch leitfähigen Kontaktlochfüllmaterial gefülltes Kontaktloch; und
- elektrisches Verbinden des zweiten Kontakts mit einem in Substratnormalenrichtung darüberliegenden, an den zweiten Kontakt angrenzenden zweiten Leiter der Metallebene ohne Zwischenschaltung eines gefüllten Kontaktlochs.

Folglich wird der erste Kontakt bzw. die ersten Kontakte - wie auch bei typischen bekannten Herstellungsverfahren - über sich in Substratnormalenrichtung erstreckende Kontaktlöcher mit entsprechenden Leitern der strukturierten Metallebene verbunden. Die Kontaktlöcher werden beispielsweise in einem Isolator, insbesondere BPSG, durch einen Lithographie- und nachfolgenden Plasmaätzschritt definiert, an welchen sich ein Metallisierungsschritt zum Füllen des Kontaktlochs mit einem Kontaktlochfüllmaterial, beispielsweise Wolfram, anschließt. Auf die polierte, der Prozeßoberfläche abgewandten Oberseite dieses vertikalen Kontaktzapfens, welcher auf der Kontaktfläche des ersten Kontakts endet, wird nachfolgend der erste Leiter der Metallebene derart definiert, daß dieser elektrisch mit dem Kontaktlochfüllmaterial verbunden ist.

Demgegenüber erfolgt die elektrische Verbindung des zweiten Kontakts mit einem zweiten Leiter der strukturierten Metallebene in anderer Weise. Hier wird kein mit einem Kontaktlochfüllmaterial gefülltes Kontaktloch eingesetzt, d.h. der vertikale Kontaktzapfen fehlt. Stattdessen grenzt die Kontaktfläche des zweiten Kontakts unmittelbar an den entsprechenden Leiter der Metallebene an, so daß eine elektrische Verbindung zwischen dem Leiter der (ersten) Metallebene mit dem zweiten Kontakt besteht. Zwischen der Kontaktfläche des zweiten Kontakts und der zweiten Leiter der strukturierten Metallebene kann jedoch eine dünne Linerschicht, insbesondere als Diffusionsstopp (z.B. aus TiN), vorhanden sein.

Dadurch, daß die Kontaktierung der Kontaktfläche des zweiten Kontakts nicht über ein Kontaktloch gemeinsam mit dem ersten Kontakt bzw. den ersten Kontakten erfolgt, sind die Prozβanforderungen an die Strukturierung des Kontaktlochs wesentlich aufgeweitet. Die Normalenhöhe des zweiten Kontakts kann nunmehr unabhängig von den Prozeßbeschränkungen der Kontaktlochstukturierung frei gewählt werden.

Vorzugsweise ist der zweite Kontakt ein Emitterkontakt eines Bipolartransistors und der erste Kontakt ein Basis- oder Kollektorkontakt eines Bipolartransistors oder ein Source-, Gate- oder Drainkontakt eines MOS-Transistors.

Vorzugsweise umfaßt der Schritt des elektrischen Verbindens des ersten Kontakts folgende Schritte:
- Definieren eines auf dem ersten Kontakt endenden, sich in Substratnormalenrichtung erstreckenden Kontaktlochs in einem Isolator;
- Füllen des Kontaktlochs mit einem elektrisch leitfähigen Kontaktlochfüllmaterial; und
- Definieren des in Substratnormalenrichtung über dem ersten Kontakt liegenden ersten Leiters der Metallebene derart, daß dieser mit dem Kontaktlochfüllmaterial elektrisch verbunden ist.

Vorzugsweise umfaßt der Schritt des elektrischen Verbindens des zweiten Kontakts folgende Schritte:
- Definieren einer in Substratnormalenrichtung orientierten freiliegenden Kontaktfläche des zweiten Kontakts durch einen planaren Polierschritt; und
- Definieren des zweiten Leiters der Metallebene derart, daß dieser an die freiliegende Kontaktfläche des zweiten Kontakts elektrisch leitend angrenzt.

Bevorzugt wird die Kontaktfläche des zweiten Kontakts durch einen planaren Polierschritt - und nicht bei dem ersten Kontakt durch einen Plasmaätzschritt - geöffnet. Besonders eignen sich hierbei bekannte CMP-Polierschritte. Beispielsweise wird nach der CVD-Abscheidung des Isolators (beispielsweise BPSG) nach dem Prozeßende FEOL der planare Polierschritt zum Zurückpolieren des Isolators (z.B. BPSG) derart ausgeführt, daß die Zielhöhe des Isolators so bemessen ist, daß der Polierschritt auf dem zweiten Kontakt endet.

In bekannter Weise können zur Festsetzung des Endpunkts des CMP-Polierschritts bekannte Endpunkterkennungssysteme eingesetzt werden. Vorzugsweise wird der zweite Kontakt selbst bei dem Polier- bzw. Planarisierungsschritt als Polierstopp verwendet. Auch können zusätzliche Strukturen vorgesehen sein, die als Polierstopp dienen.

Da während des Lithographie- und Plasmaätzschritts des Kontaktlochs zur Kontaktierung des ersten Kontakts die zuvor freigelegte Kontaktfläche des zweiten Kontakts durch einen Photoresist geschützt ist, wird dieser bei dem Plasmaätzschritt nicht angegriffen. Die Kontaktierung der freigelegten Kontaktfläche des zweiten Kontakts kann somit einfach dadurch erfolgen, daß der zweite Leiter der Metallebene auf diese Kontaktfläche aufgebracht wird. Vorteilhaft kann es sein, vor der Definition des zweiten Leiters der Metallebene (beispielsweise eine mit einem MCVD-Verfahren aufgebrachte und nachfolgend strukturierte AlCu-Ebene) einen sogenannten Liner (beispielsweise TiN) aufzusputtern, welcher als Migrationsstopp fungiert.

Alternativ zu dem Freilegen der Kontaktfläche des zweiten Kontakts durch einen Polierschritt des Isolators (beispielsweise BPSG), kann diese auch durch einen späteren polierschritt des Kontaktlochfüllmaterials freigelegt werden.

Die Erfindung wird nachfolgend mit Bezug auf begleitende Zeichnungen bevorzugter Ausführungsformen beispielhaft beschrieben. Es zeigt:
- **Figs. 1** bis **14**: schematische Schnittansichten einer bevorzugten Ausführungsform einer Halbleitervorrichtung gemäß der Erfindung in unterschiedlichen Strukturierungs- bzw. Prozessierungsstadien während des Herstellungsverfahrens;
- **Fig. 15**: eine schematische Schnittansicht einer Ausführungsform einer Halbleitervorrichtung gemäß dem zweiten Aspekt; und
- **Fig. 16**: eine Schnittansicht einer herkömmlichen Halbleitervorrichtung.

In **Fig. 1** ist eine Schnittansicht einer bevorzugten Ausführungsform einer Halbleitervorrichtung gemäß der Erfindung dargestellt. Die Halbleitervorrichtung befindet sich in einem Prozeßstadium, in welchem die aktiven Bauelemente - wie der Bipolartransistor 10 und der MOS-Transistor 20 - bereits fertiggestellt worden sind. Das Prozessende der FEOL (front end of line), bei dem insbesondere Hochtemperaturschritte auftreten können, ist somit bereits erreicht.

Wie in **Fig. 1** gezeigt ist, wird in dem nachfolgenden Prozessierungsschritt die gesamte Halbleitervorrichtung mit einem dielektrischen Isolator 30, bei welchem es sich beispielsweise um BPSG (Bor-Phosphor-Silikat-Glas) handelt, vorzugsweise mittels einer CVD-Abscheidung bedeckt (Schritt: CVD BPSG). Typischerweise wird die Isolatorschicht 30 mit einer Schichthöhe von ca. 1400 nm aufgebracht. Diese Schichtdecke ist wesentlich größer als die Höhe des Emitterkontakts 14, welche typischerweise 550 nm beträgt, sowie des Gatekontakts 24, welche typischerweise 280 nm beträgt.

In einem nächsten, in **Fig. 2** dargestellten Prozeßschritt wird die Isolatorschicht 30 durch einen Polierschritt auf eine Zielhöhe von typischerweise 700 nm ± 150 nm zurückpoliert, wozu bekannte CMP (chemical mechanical planarization) Schritte eingesetzt werden (Schritt: CMP BPSG).

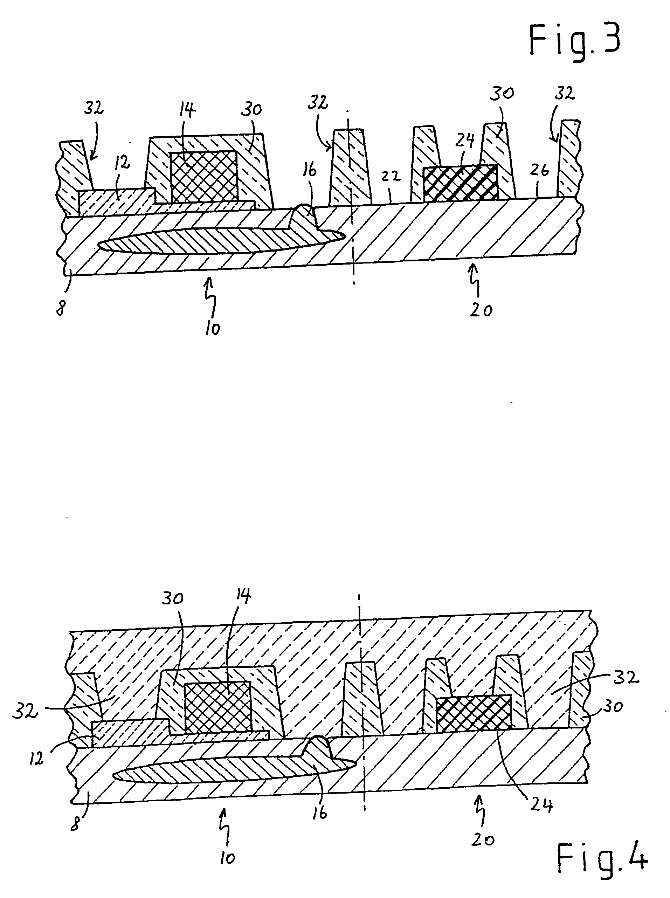

Wie in **Fig. 3** dargestellt ist, werden nachfolgend durch einen Lithographie- und anschließenden Ätzschritt Kontaktlöcher 32 in der Isolatorschicht 30 definiert (Schritt CT Etch). Diese Kontaktlöcher 32 erstrecken sich in Normalenrichtung des Substrats 8, d.h. sie weisen eine vertikale Orientierung auf. Im Unterschied zu einem herkömmlichen Herstellungsverfahren beispielsweise einer Halbleitervorrichtung, wie sie.in **Fig. 16** dargestellt ist, wird kein Kontaktloch 32 definiert, welches auf einer Kontaktfläche des Emitterkontakts 14 endet. Mit anderen Worten wird kein zu der Kontaktfläche des Emitterkontakts 14 führendes Fenster in die Isolatorschicht 30 geätzt.

Der Emitterkontakt 14, welcher bei dieser Ausführungsform der Halbleitervorrichtung der zweite (höhere) Kontakt ist, wird daher bei den nachfolgenden Metallisierungsschritten nicht kontaktiert. Dadurch, daß auf eine Kontaktierung des Emitterkontakts 14 (des zweiten Kontakts) in diesem Prozeßstadium verzichtet wird, braucht die Stukturierung der Kontaktlöcher 33, d.h. der Polierschritt CMP BPSG sowie der Plasmaätzschritt CT Etch, nicht auf eine prozeßtechnisch aufwendige, gleichzeitige Kontaktierung des ersten und des zweiten Kontakts angepaßt zu werden.

Hierdurch wird das Prozeßfenster für den Polierschritt CMP BPSG, dessen Ergebnis in **Fig. 2** dargestellt ist, sowie für den Plasmaätzschritt CT Etch (vgl. **Fig. 3****)**, gegenüber einem Herstellungsverfahren der in **Fig. 16** gezeigten Halbleitervorrichtung erheblich aufgeweitet. Die zulässige Höhe in Substratnormalenrichtung des zweiten Kontakts 14 muß demgemäß nicht mehr unter Berücksichtigung der Strukturierung der Kontaktlöcher 32 gewählt werden. Stattdessen kann gemäß dem erfindungsgemäßen Herstellungsverfahren einer Halbleitervorrichtung nach der Erfindung die Höhe des Emitterkontakts 14 freigewählt bzw. den Prozeßanforderungen eines optimierten Bipolartransistors angepaßt werden. Durch die Aufhebung der topologiebedingten Beschränkungen der Höhe des Emitterkontakts 14 können neu zu entwickelnde Kontaktlochätzungen für Bipolarbauelemente zukünftiger Techologieplattformen vermieden werden.

In **Fig. 4** ist die bevorzugte Ausführungsform der erfindungsgemäßen Halbleitervorrichtung nach der Erfindung nach Abschluß der Kontaktlochmetallisierung dargestellt. Zunächst wird vorzugsweise ein sogenannter Liner, welcher beispielsweise aus TiN besteht und welcher insbesondere als Diffusionsstopp dient, aufgesputtert. Nachfolgend wird beispielsweise mittels eines MCVD-Verfahrens beispielsweise Wolfram abgeschieden, welches als Kontaktlochfüllmaterial die Kontaktlöcher 32 füllt.

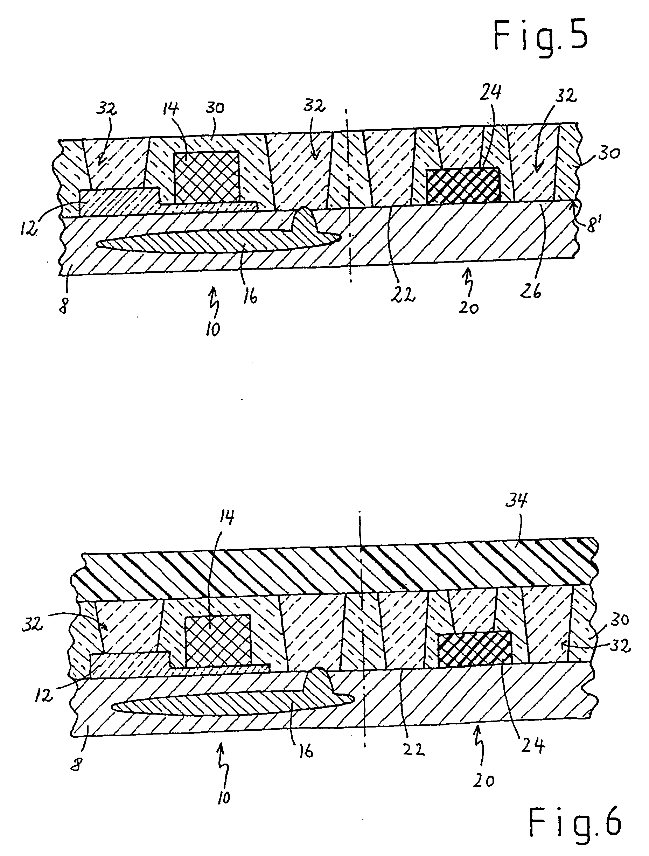

Die in **Figs. 4** bis **9** dargestellten Prozeßschritte entsprechen jeweiligen Schritten eines herkömmlichen Herstellungsverfahren einer Halbleitervorrichtung, wie sie beispielsweise in **Fig. 16** dargestellt ist. Somit wird - in üblicher Weise - mittels eines Planarisierungsschritts (Schritt: CMP W) das elektrisch leitfähige Kontaktlochfüllmaterial bis auf eine Zielhöhe zurückpoliert. Die Zielhöhe wird hierbei derart gewählt, daß der Emitterkontakt 14 (der zweite Kontakt) nicht geöffnet wird (vergleiche **Fig. 5**) und keine Reste des Füllmaterials oder des Liners außerhalb der definierten Kontaktlöcher vorhanden sind.

Zur Ausbildung der ersten strukturierten Metallebene 34 kann anschließend ein Metall auf die Halbleitervorrichtung aufgesputtert werden, welches beispielsweise AlCu sein kann (vgl. **Fig. 6**; Schritt: Sputter Metall 1). Die Schichtdicke dieser ersten Metallebene 34 kann abhängig von den Designanforderungen gewählt werden und beträgt typischerweise etwa 400 nm.

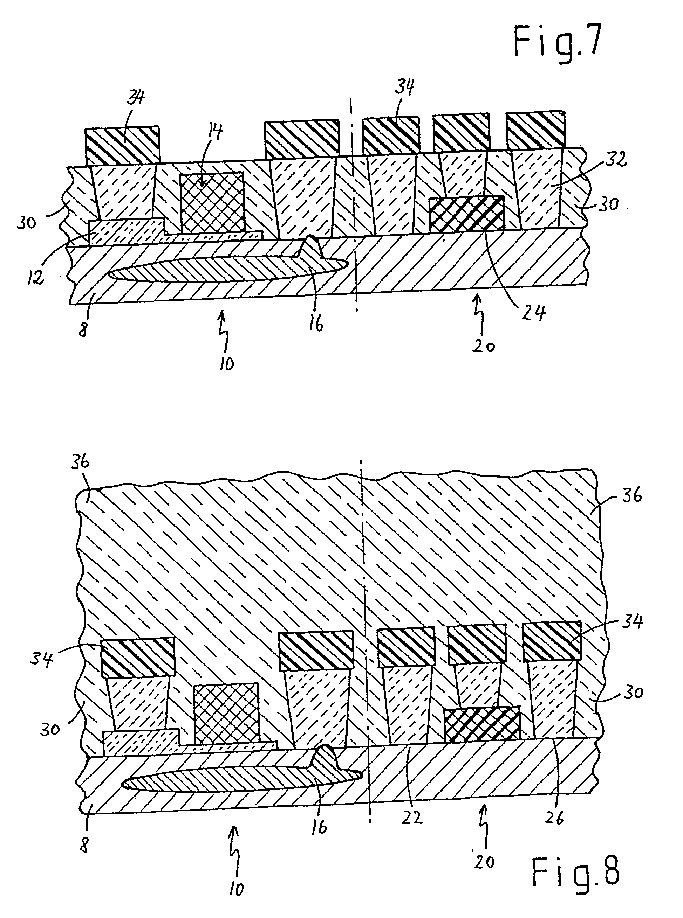

Mit einem nachfolgenden Lithographie- und Ätzschritt (Schritt: Etch Metall 1) wird die erste Metallebene 34 derart strukturiert, daß über den beispielsweise mit Wolfram gefüllten Kontaktlöchern 32 elektrische Leiter bzw. Anschlußkontakte in der ersten Metallebene 34 ausgebildet werden. Wie in **Fig. 7** dargestellt ist, sind alle (ersten) Kontakte 12, 16, 22, 24 und 26 über Kontaktlöcher mit entsprechenden, in Substratnormalenrichtung darüberliegenden Leitern der ersten Metallebene 34 verbunden. Lediglich über dem zweiten Kontakt 14, bei welchem es sich bei der vorliegenden Ausführungsform um den Emitterkontakt handelt, ist kein Leiter der ersten Metallebene 34 in Substratnormalenrichtung über dem Kontakt 14 angeordnet.

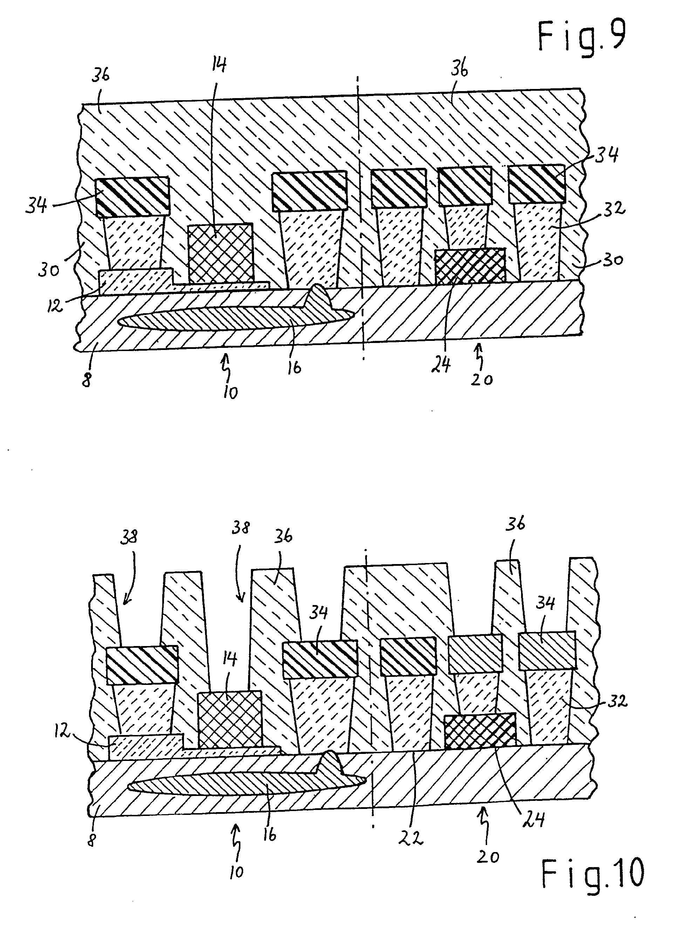

Anschließend erfolgt in einem Abscheideschritt das Aufbringen eines weiteren Dielektrikums bzw. Isolators (Schritt: deposit ILD1 (interlayer dielectric 1)). **Fig. 8** zeigt die Halbleitervorrichtung nach Beendigung dieses Abscheideschrittes. In herkömmlicher Weise wird nachfolgend mittels eines weiteren Polierschritts (Schritt: CMP ILD1) das zuvor abgeschiedene Dielektrikum auf eine Zielhöhe zurückpoliert (vgl. **Fig. 9**).

Ähnlich wie in dem anhand von **Fig. 3** erläuterten Strukturierungsschritt der Isolatorschicht 30 werden nachfolgend mittels eines Lithographie- und Äztschrittes Kontaktlöcher 38 in das Dielektrikum 36 (ILD) eingebracht (Schritt: Etch VIA1). Im Unterschied zu einem herkömmlichen Herstellungsverfahren beispielsweise einer Halbleitervorrichtung gemäß **Fig. 16** werden jedoch nicht nur die Kontaktlöcher 38 strukturiert, die auf Leitern der ersten Metallebene 34 enden, sondern ebenfalls ein Kontaktloch 38, welches auf der Kontaktfläche des Emitterkontakts 14 (des zweiten Kontakts) endet.

Ein Fenster zu dem Emitterkontakt 14 wird somit vorzugsweise erst bei der Strukturierung der sogenannten VIA-1-Verbindungskanäle, welche standardmäßig Leiter der ersten Metallebene 34 mit entsprechenden der zweiten Metallebene 40 verbinden, geöffnet. Folglich erfolgt die Kontaktierung des Emitterkontakts 14 im Unterschied zum Stand der Technik vorzugsweise über eine VIA1-Kontaktlochverbindung zu der zweiten Metallisierungsebene.

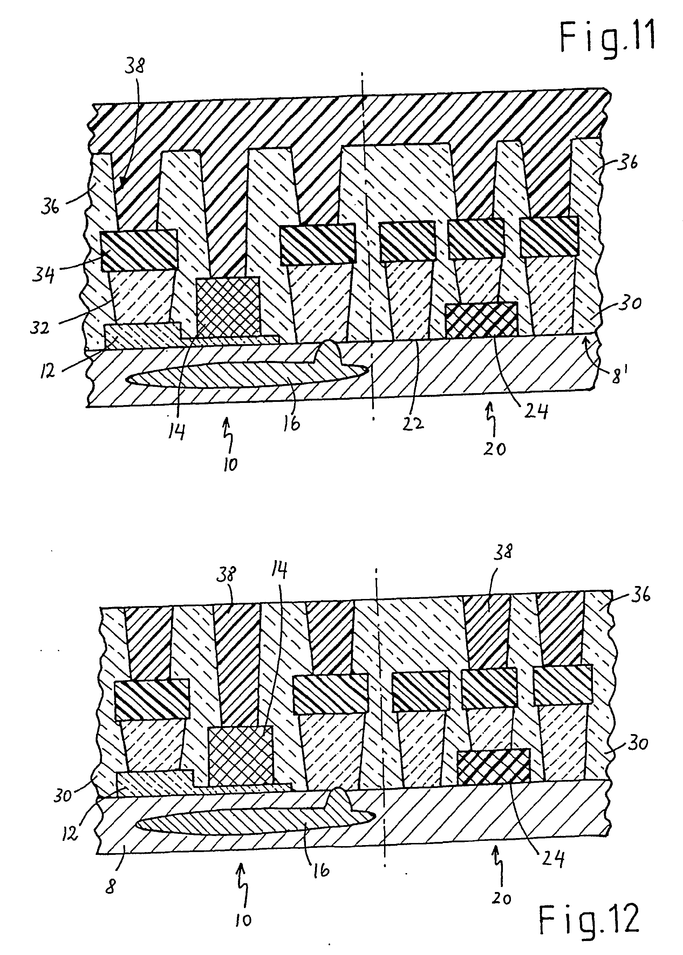

Ähnlich zu dem anhand von **Fig. 4** beschriebenen Metallisierungsschritt erfolgt anschließend ein Füllen der Kontaktlöcher 38 mit einem elektrisch leitfähigen Kontaktfüllmaterial. Erneut wird zunächst ein Liner (TiN) als Diffusionsstopp aufgesputtert (Schritt: Sputter Liner). Anschließend wird mittels eines MCVD Verfahrens ein geeignetes Metall (beispielsweise Wolfram) abgeschieden (Schritt MCVD W; vgl. **Fig. 11**) und mittels eines weiteren planaren Polierschritts (Schritt: CMP W; vgl. **Fig. 12**) auf eine Zielhöhe zurückpoliert. Die Strukturierung der zweiten Metallebene 40 erfolgt in gleicher Weise wie die Strukturierung der ersten Metallebene 34, welche anhand von **Figs. 6** und **7** beschrieben worden ist.

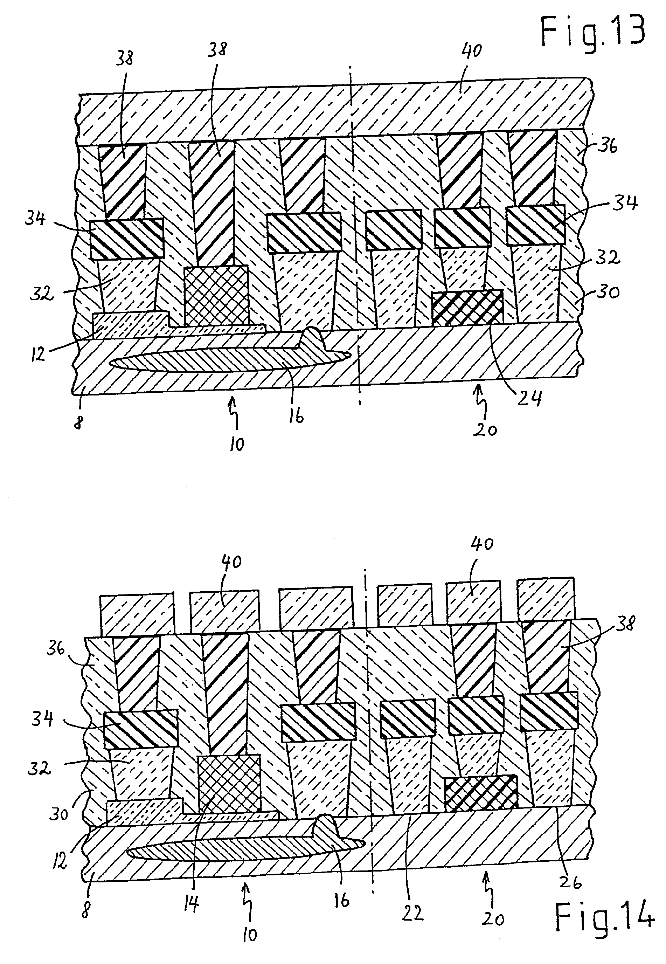

Die bevorzugte Ausführungsform der Halbleitervorrichtung gemäß der Erfindung nach Abschluß der erfindungsgemäßen Verfahrensschritte ist in **Fig. 14** dargestellt. Wie oben bereits detailliert ausgeführt wurde, unterscheidet sich diese Halbleitervorrichtung von einer in **Fig. 16** dargestellten bekannten Halbleitervorrichtung insbesondere dadurch, daß der zweite Kontakt 14 (der Emitterkontakt in dieser Ausführungsform) nicht durch eine gefülltes Kontaktloch 32 mit einem Leiter der ersten Metallebene 34 verbunden ist, sondern vorzugsweise über den sogenannten VIA-1-Verbindungskontakt unmittelbar mit der zweiten Metallisierungsebene 40. Zwischen der Kontaktfläche des zweiten Kontakts 14 und dem Leiter der zweiten Metallisierungsebene 40, welcher in Substratnormalenrichtung über dem Kontakt 14 angeordnet ist, ist kein Leiter der ersten Metallebene 34 angeordnet.

Da der sogenannte VIA-1-Verbindungskontakt, welcher standardmäßig Leiter der ersten mit der zweiten Metallebene verbindet, ohnehin gemäß einem Standardprozeß ausgebildet werden muß, führt die Kontaktierung des zweiten Kontakts 14 über die zweite Metallebene 40 nicht zu zusätzlichen Prozeßschritten. Die VIA-1-Äztung über dem Kontakt 14 wird demgemäß nicht durch einen Leiter der ersten Metallebene gestoppt, sondern endet auf dem Polysilizium des Emitterkontakts 14. Der Durchbruch durch die Liner, die als Ätzstopp dienen können, in die erste Metallebene 34 bzw. in das Polysilizium des Emitterkontakts 14 erfolgen somit gleichzeitig und kontrolliert.

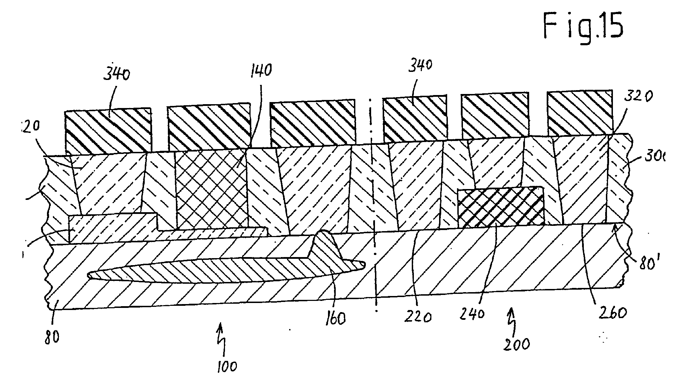

In **Fig. 15** ist eine Halbleitervorrichtung gemäß dem zweiten Aspekt, welcher lediglich als technologischer Hintergrund der Erfindung beschrieben wird, nach Abschluß der Herstellungsverfahrensschritte dargestellt. Die Halbleitervorrichtung weist ein Substrat 80, bei dem es sich um ein Siliziumhalbleitersubstrat handeln kann, mit einer Prozeßoberfläche 80' auf. Die aktiven Bauelemente, welche in dem FEOL-Prozeßschritten strukturiert wurden, können beispielsweise denjenigen der zuvor beschriebenen bevorzugten Ausführungsform der Halbleitervorrichtung gemäß der Erfindung entsprechen.

In der in **Fig. 15** dargestellten bevorzugten Ausführungsform ist ein Bipolartransistor 100 mit einem Basiskontakt 120 (erster Kontakt), einem den zweiten (höherliegenden) Kontakt darstellenden Emitterkontakt 140 sowie einem Kollektorkontakt 160 (erster Kontakt). Der Bipolartransistor 100 kann beispielsweise ein Teil eines Hochfrequenzschaltkreises der Halbleitervorrichtung sein. Ferner weist die in **Fig. 15** dargestellte Ausführungsform der Halbleitervorrichtung eine CMOS-Schaltung auf, welche durch einen MOS-Transistor 200 vereinfacht dargestellt ist. Der MOS-Transistor 200 umfaßt einen Source-Kontakt 220, einen aus Polysilizium bestehenden Gate-Kontakt 240 sowie einen Drainkontakt 260. Die Kontakte 220, 240 sowie 260 sind erste Kontakte im Sinne der Erfindung.

Die bereits in Zusammenhang mit **Fig. 1** beschrieben worden ist, wird nach dem Prozeßende FEOL die Halbleitervorrichtung mit einem Isolator 300, bei welchem es sich beispielsweise um BPSG (Bor-Phorphor-Silikat-Glas) handelt, beispielsweise mittels eines CVD-Abscheideverfahrens bedeckt.

Im Unterschied zu dem Herstellungsverfahren gemäß der Erfindung und bekannten Herstellungsverfahren wird jedoch der nachfolgende planare Polierschritt (Schritt: CMD BPSG) derart ausgeführt, daß bis auf den zweiten Kontakt (d.h. den Emitterkontakt 140) zurückpoliert wird. Der CMP-Prozeßschritt wird somit auf dem Emitterkontakt 140 gestoppt. Hierzu kann in bekannter Weise ein Endpunkterkennungssystem Verwendung finden, welches den Zeitpunkt anzeigt, bei dem der Polierschritt auf dem zweiten Kontakt 140 angelangt ist. Auch können zusätzliche Hilfsstrukturen vorgesehen sein, welche als Polierstopp fungieren.

Wie bereits detailliert anhand von Figs. 3 bis 5 beschrieben worden ist, erfolgt anschließend die Strukturierung von Kontaktlöchern 320 in dem Isolator 300 mittels eines Lithographie- und eines Ätzschritts (Schritt: CT Etch). Jedoch wird über dem Emitterkontakt 140 im Unterschied zu einer herkömmlichen Halbleitervorrichtung gemäß Fig. 16 kein Kontaktloch 320 strukturiert. Die Kontaktlöcher 320 können in üblicher Weise mit einem Liner (beispielsweise aus TiN) ausgekleidet und mit einem geeigneten Kontaktlochfüllmaterial, beispielsweise Wolfram, gefüllt werden. Die beispielsweise mit einem MCVD-Verfahren aufgebrachte Metallschicht wird in einem nachfolgenden planaren Polierschritt (CMP W) auf eine deratige Zielhöhe zurückpoliert, daß die.Kontaktfläche des Emitterkontakts 140 (des zweiten Kontakts) freigelegt wird. Somit kann der Polierschritt des Kontaktlochfüllmaterials der Kontaktlöcher 320 ebenfalls zur Öffnung (sowie Beseitigung von Linerresten) der Kontaktfläche des zweiten Kontakts 140 benutzt werden.

Anschließend erfolgt die Definition der (ersten) strukturierten Metallebene 340, deren Prozeßschritte sich von einem herkömmlichen Standardverfahren zur Definition derartiger Metallebenen nicht unterscheidet. Zu bemerken ist, daß ein Leiter der Metallebene 340, welcher in Substratnormalenrichtung über dem zweiten Kontakt 140 angeordnet ist, an diesen unmittelbar angrenzt, so daß eine elektrisch leitfähige Verbindung zwischen dem zweiten Kontakt 140 (dem Emitterkontakt) und dem entsprechenden (zweiten) Leiter der Metallebene 340 erstellt wird. In anderen Worten ist der zweite Kontakt 140 im Unterschied zu den übrigen Kontakten der Halbleitervorrichtung mit dem zugeordneten zweiten Leiter der Metallebene 340 nicht durch einen Kontaktlochzapfen 320 verbunden. Stattdessen erfolgt die Kontaktierung des zweiten Kontakts 140 unmittelbar durch den daran angrenzenden Leiter der ersten Metallbebene 340. Zwischen dem zweiten Kontakt und dem zweiten Leiter der Metallebene 340 kann, beispielsweise zur Senkung des Kontaktwiderstands, eine dünne, insbesondere metallische Zwischenschicht vorhanden sein.

Vorteilhaft an diesem Herstellungsverfahren bzw. an der somit erhaltenen Halbleitervorrichtung ist, daß die Höhe des zweiten Kontakts 140 in Substratnormalenrichtung frei gewählt bzw. den Prozeßanforderungen eines optimierten Bipolartransistors angepaßt werden kann. Die Dickenmessung über STI entfällt. Gleichzeitig reduziert sich die Unsicherheit in der Messung der Schichtdicke des Isolators 300 (der BPSG-Schicht) nach dem Polierschritt CMP BPSG (welche ± 150 nm beträgt) und das Risiko des Überpolierens wird minimiert bzw. ausgeschlossen. Das Kontaktieren des zweiten Kontakts mittels eines mit Kontaktlochfüllmaterial (beispielsweise Wolfram) gefüllten Kontaktlochs 320 entfällt. Die erste Metallebene 340 kann direkt (ohne Kontaktlochzapfen 320) mit dem Emitterkontakt 140 verbunden werden.

Die Beschränkung der Kontaktfläche, d.h. der Durchmesser der Kontaktlöcher 320, entfällt, da die gesamte effektive Fläche des zweiten Kontakts 140 zur Kontakterstellung genutzt werden kann. Somit können größere Stromstärken in dem Bipolartransistor 100 realisiert bzw. der Fläche des Emitterkontakts 140 optimal angepaßt werden.

### Bezugszeichenliste

für die bevorzugte Ausführungsform gemäß der Erfindung und dem Stand der Technik:
- 8: Substrat (z.B. Siliziumhalbleitersubstrat)
- 8': Prozeßoberfläche des Substrats 8
- 10: Bipolartransistor
- 12: Basiskontakt des Bipolartransistors
- 14: Emittorkontakt (Emitterstack) des Bipolartransistors
- 16: Kollektorkontakt des Bipolartransistors
- 20: MOS-Transistor
- 22: Drain-Kontakt des MOS-Transistors
- 24: Gate-Kontakt des MOS-Transistors
- 26: Source-Kontakt des MOS-Transistors
- 30.: Isolator (z.B. BPSG)
- 32: Kontaktloch (CT) gefüllt mit Kontaktlochfüllmaterial (z.B. W)
- 34: strukturierte erste Metallebene mit Leitern
- 36: Dielektrikum (Isolator) ILD (z.B. TEOS)
- 38: Kontaktloch (VIA-1) gefüllt mit Kontaktlochfüllmaterial
- 40: strukturierte zweite Metallebene mit Leitern für die bevorzugte Ausführungsform gemäß dem zweiten Aspekt:
- 80: Substrat (z.B. Siliziumhalbleitersubstrat)
- 80': Prozeßoberfläche des Substrats 80
- 100: Bipolartransistor
- 120: Basiskontakt des Bipolartransistors
- 140: Emittorkontakt (Emitterstack) des Bipolartransistors
- 160: Kollektorkontakt des Bipolartransistors
- 200: MOS-Transistor
- 220: Drain-Kontakt des MOS-Transistors
- 240: Gate-Kontakt des MOS-Transistors
- 260: Source-Kontakt des MOS-Transistors
- 300: Isolator (z.B. BPSG)
- 320: Kontaktloch (CT) gefüllt mit Kontaktlochfüllmaterial (z.B. W)
- 340: strukturierte erste Metallebene mit Leitern

## Patentansprüche

1. Verfahren zur Herstellung einer Halbleitervorrichtung mit den Schritten:
- Bereitstellen eines Substrats (8), dessen Prozeßoberfläche (8') eine Substratnormalenrichtung aufweist;
- Definieren zumindest eines ersten (12, 16, 22, 24, 26) und eines zweiten (14) Kontakts auf dem Substrat (8), wobei eine Kontaktfläche des zweiten Kontakts (14) in Substratnormalenrichtung weiter von dem Substrat (8) als eine Kontaktfläche des ersten Kontakts (12, 16, 22,24, 26) beabstandet ist, wobei der zweite Kontakt (14) ein Emitterkontakt eines Bipolartransistors (10) und der erste Kontakt ein Basis- (12) oder Kollektorkontakt (16) eines Bipolartransistors oder ein Source- (22), Gate- (24) oder Drainkontakt (26) eines MOS-Transistors (20) ist;
- elektrisches Verbinden des ersten Kontakts (12, 16, 22, 24, 26) mit einem in Substratnormalenrichtung darüberliegenden Leiter einer ersten strukturierten Metallebene (34) über ein verfülltes Kontaktloch (32); und
- anschließendes elektrisches Verbinden des zweiten Kontakts (14) mit einem in Substratnormalenrichtung darüberliegenden Leiter, einer zweiten strukturierten Metallebene (40) ohne Zwischenschaltung eines Leiters der ersten Metallebene (34); wobei die zweite Metallebene (40) in Substratnormalenrichtung weiter von dem Substrat (8) als die erste Metallebene (34) beabstandet ist und
wobei der Schritt des elektrisches Verbindens des ersten Kontakts (12, 16, 22, 24, 26) mit dem in Substratnormalenrichtung darüberliegenden Leiter der ersten strukturierten Metallebene (34) das Definieren eines auf dem ersten Kontakt (12, 16, 22, 24, 26) endenden, sich in Substratnormalenrichtung erstreckenden Kontaktlochs (32) in einem Isolator (30) umfasst, wobei kein Kontaktloch definiert wird, das auf einer Kontaktfläche des zweiten Kontakts (14) endet.

2. Verfahren nach Anspruch 1, wobei gleichzeitig mit dem Schritt des elektrischen Verbindens des zweiten Kontakts (14) mit dem Leiter der zweiten Metallebene (40) zumindest ein Leiter der ersten Metallebene (34) mit einem Leiter der zweiten Metallebene (40) über ein verfülltes Kontaktloch (38) verbunden wird.

3. Verfahren nach Anspruch 1 oder 2, wobei der Schritt des elektrischen Verbindens des ersten Kontakts (12, 16, 22, 24, 26) folgende Schritte umfaßt:
- Füllen des Kontaktlochs (32) mit einem elektrisch leitfähigen Kontaktlochfüllmaterial; und
- Definieren des in Substratnormalenrichtung über dem ersten Kontakt (12, 16, 22, 24, 26) liegenden Leiters der ersten Metallebene (34) derart, daß dieser mit dem Kontaktlochfüllmaterial elektrisch verbunden ist.

4. Verfahren nach einem der Ansprüche 1 bis 3, wobei der Schritt des elektrischen Verbindens des zweiten Kontakts (14) folgende Schritte umfaßt:
- Definieren eines auf dem zweiten Kontakt (14) endenden, sich in Substratnormalenrichtung erstreckenden Kontaktlochs (38) in einem Isolator (36);
- Füllen des Kontaktlochs (38) mit einem elektrisch leitfähigen Kontaktlochfüllmaterial; und
- Definieren des in Substratnormalenrichtung über dem zweiten Kontakt (14) liegenden Leiters der zweiten Metallebene (40) derart, daß dieser mit dem Kontaktlochfüllmaterial ohne Zwischenschaltung eines Leiters der ersten Metallebene (34) elektrisch verbunden ist.

## Claims

1. Method for producing a semiconductor device, comprising the following steps:
- providing a substrate (8), the process surface (8') of which has a substrate-normal direction;
- defining at least a first contact (12, 16, 22, 24, 26) and a second contact (14) on the substrate (8), wherein a contact area of the second contact (14) is located at a greater distance, in the substrate-normal direction, from the substrate (8) than a contact area of the first contact (12, 16, 22, 24, 26), wherein the second contact (14) is an emitter contact of a bipolar transistor (10) and the first contact is a base contact (12) or collector contact (16) of a bipolar transistor or a source contact (22), gate contact (24) or drain contact (26) of a MOS transistor (20);
- electrically connecting the first contact (12, 16, 22, 24, 26) to a conductor, located above it in the substrate-normal direction, of a first patterned metal plane (34) via a filled contact hole (32); and
- subsequently electrically connecting the second contact (14) to a conductor, located above it in the substrate-normal direction, of a second patterned metal plane (40) without the interposition of a conductor of the first metal plane (34);
wherein the second metal plane (40) is located at a greater distance, in the substrate-normal direction, from the substrate (8) than the first metal plane (34), and
wherein the step of electrically connecting the first contact (12, 16, 22, 24, 26) to the conductor, located above it in the substrate-normal direction, of the first patterned metal plane (34) comprises defining a contact hole (32), which ends at the first contact (12, 16, 22, 24, 26) and extends in the substrate-normal direction, in an insulator (30), wherein no contact hole is defined which ends at a contact area of the second contact (14).

2. Method according to Claim 1, wherein at the same time as the step of electrically connecting the second contact (14) to the conductor of the second metal plane (40), at least one conductor of the first metal plane (34) is connected to a conductor of the second metal plane (40) via a filled contact hole (38).

3. Method according to Claim 1 or 2, wherein the step of electrically connecting the first contact (12, 16, 22, 24, 26) comprises the following steps:
- filling the contact hole (32) with an electrically conductive contact hole filling material; and
- defining the conductor, which lies above the first contact (12, 16, 22, 24, 26) in the substrate-normal direction, of the first metal plane (34) in such a way that it is electrically connected to the contact hole filling material.

4. Method according to any of Claims 1 to 3, wherein the step of electrically connecting the second contact (14) comprises the following steps:
- defining a contact hole (38), which ends at the second contact (14) and extends in the substrate-normal direction, in an insulator (36);
- filling the contact hole (38) with an electrically conductive contact hole filling material; and
- defining the conductor, which lies above the second contact (14) in the substrate-normal direction, of the second metal plane (40) in such a way that it is electrically connected to the contact hole filling material without the interposition of a conductor of the first metal plane (34).

## Revendications

1. Procédé de fabrication d'un dispositif à semiconducteur comprenant les étapes consistant à :
- fournir un substrat (8) dont la surface de traitement (8') présente une direction normale au substrat ;
- définir au moins un premier (12, 16, 22, 24, 26) et un second (14) contacts sur le substrat (8), dans lequel une surface de contact du second contact (14) est plus espacée, dans le sens de la normale au substrat, du substrat (8) qu'une surface de contact du premier contact (12, 16, 22, 24, 26), dans lequel le second contact (14) est un contact d'émetteur d'un transistor bipolaire (10) et le premier contact est un contact de base (12) ou de collecteur (16) d'un transistor bipolaire ou un contact de source (22), de grille (24) ou de drain (26) d'un transistor MOS (20) ;
- connecter électriquement le premier contact (12, 16, 22, 24, 26) à un conducteur superposé à celui-ci, dans une direction normale au substrat, d'une première couche métallique structurée (34) par l'intermédiaire d'un trou de contact rempli (32) ; et
- connecter ensuite électriquement le second contact (14) à un conducteur superposé à celui-ci, dans une direction normale au substrat, d'une seconde couche métallique structurée (40) sans interposition d'un conducteur de la première couche métallique (34) ;
dans lequel la seconde couche métallique (40) est plus espacée du substrat (8), dans une direction normale au substrat, que la première couche métallique (34) et dans lequel l'étape de connexion électrique du premier contact (12, 16, 22, 24, 26) au conducteur superposé à celui-ci dans une direction normale au substrat de la première couche métallique structurée (34), consiste à définir, dans un isolant (30), un trou de contact (32) se terminant sur le premier contact (12, 16, 22, 24, 26) et s'étendant dans une direction normale au substrat, dans lequel il n'est défini aucun trou de contact se terminant sur une surface de contact du second contact (14).

2. Procédé selon la revendication 1, dans lequel, en même temps que l'étape de connexion électrique du second contact (14) au conducteur de la seconde couche métallique (40), au moins un conducteur de la première couche métallique (34) est connecté à un conducteur de la seconde couche métallique (40) par l'intermédiaire d'un trou de contact rempli (38).

3. Procédé selon la revendication 1 ou 2, dans lequel l'étape de connexion électrique- du premier contact (12, 16, 22, 24, 26) comprend les étapes consistant à :
- remplir le trou de contact (32) d'un matériau de remplissage de trou de contact électriquement conducteur ; et
- définir le conducteur de la première couche métallique (34), disposé au-dessus du premier contact (12, 16, 22, 24, 26) dans une direction normale au substrat, de telle manière qu'il soit électriquement connecté au matériau de emplissage du trou de contact.

4. Procédé selon l'une des revendications 1 à 3, dans lequel l'étape de connexion électrique du second contact (14) comprend les étapes consistant à :
- définir un trou de contact (38), dans un isolant (36), se terminant sur le second contact (14) et s'étendant dans une direction normale au substrat ;
- remplir le trou de contact (38) d'un matériau de remplissage de trou de contact électriquement conducteur ; et
- définir le conducteur de la seconde couche métallique (40), disposé au-dessus du second contact (14) dans une direction normale au substrat, de telle manière qu'il soit électriquement connecté au matériau de remplissage du trou de contact sans interposition d'un conducteur de la première couche métallique (34).
